# NEUE EUROPÄISCHE PATENTSCHRIFT

(11) **EP 0 822 445 B2**
(45) Veröffentlichungstag und Bekanntmachung des Hinweises auf die Entscheidung über den Einspruch: **09.02.2005**
(45) Hinweis auf die Patenterteilung: 22.03.2000
(21) Anmeldenummer: 97810510.4
(22) Anmeldetag: 21.07.1997
(51) Int. Cl.: G03C 9/08, G03F 7/027, G03F 7/038

(54) **Flüssige, strahlungshärtbare Zusammensetzung, insbesondere für die Stereolithographie**
Liquid radiation-curable compositions, in particular for stereolithography
Compositions liquides, durcissables par irradiation, en particulier pour la stéréolithographie

(30) Priorität: 29.07.1996 CH 188596; 05.09.1996 CH 220196
(43) Veröffentlichungstag der Anmeldung: 04.02.1998
(73) Patentinhaber: Huntsman Advanced Materials (Switzerland) GmbH, 4057 Basel (CH)
(72) Erfinder: Steinmann, Bettina, 1724 Praroman (CH); Schulthess, Adrian, 1734 Tentlingen (CH)
(74) Vertreter: Hedley, Nicholas James Matthew

(56) Entgegenhaltungen:
- EP-A- 0 509 512
- EP-A- 0 604 364
- EP-A- 0 605 361
- EP-A- 0 646 580
- WO-A-96/41238
- JP-A- 2 075 618
- US-A- 4 156 035
- US-A- 4 694 029

## Beschreibung

Die vorliegende Erfindung betrifft eine flüssige, strahlungshärtbare Zusammensetzung, die sich insbesondere für die Herstellung dreidimensionaler Formkörper mit Hilfe der Stereolithographie eignet, ein Verfahren zur Herstellung eines gehärteten Produkts und insbesondere zur stereolithographischen Herstellung eines dreidimensionalen Formkörpers aus dieser Zusammensetzung.

Die Herstellung kompliziert geformter dreidimensionaler Körper mit Hilfe der Stereolithographie ist seit län-. gerem bekannt. Man baut hierbei den gewünschten Formkörper aus einer flüssigen strahlungshärtbaren Zusammensetzung mit Hilfe einer sich wiederholenden abwechselnden Abfolge zweier Verfahrensschritte (a) und (b) auf, wobei in Schritt (a) eine Schicht der flüssigen, strahlungshärtbaren Zusammensetzung, deren eine Begrenzung die Oberfläche der Zusammensetzung ist, mit Hilfe von geeigneter, im allgemeinen von einer, bevorzugt computergesteuerten, Laserquelle erzeugten Strahlung innerhalb eines Flächenbereiches gehärtet wird, der der gewünschten Querschnitts. fläche des zu bildenden Formkörpers in der Höhe dieser Schicht entspricht, und in Schritt (b) die gehärtete Schicht mit einer neuen Schicht der flüssigen, strahlungshärtbaren Zusammensetzung überschichtet wird und die Abfolge der Schritte (a) und (b) solange wiederholt wird, bis ein sogenannter Grünling der gewünschten Form fertig ist. Dieser Grünling ist im allgemeinen noch nicht völlig ausgehärtet und muss daher normalerweise noch nachgehärtet werden.

Die mechanische Festigkeit des Grünlings (Elastizitätsmodul, Bruchfestigkeit), auch-als Grünfestigkeit bezeichnet, stellt eine wichtige Eigenschaft des Grünlings dar und wird wesentlich von der Art der eingesetzten Stereolithographieharzzusammensetzung bestimmt. Weitere wichtige Eigenschaften einer Stereolithographieharzzusammensetzung sind u. a. eine hohe Empfindlichkeit für die bei der Härtung zur Anwendung kommende Strahlung und ein möglichst niedriger Curl-Faktor, der eine hohe Formtreue des Grünlings erwarten lässt. Weiterhin sollen beispielsweise die vorgehärteten Materialschichten gut von der flüssigen Siereolfthographieharzzusamrnensetzung benetzbar sein und es soll selbstverständlich nicht nur der Grünling sondern auch der endgültig ausgehärtete Formkörper möglichst gute mechanische'Eigenschaften aufweisen.

Flüssige, strahlungshärtbare Zusammensetzungen für die Stereolithographie, die den.oben genannten Anforderungen gerecht werden, sind z. B. in der EP-A-0 605 361 beschrieben. Bei diesen Zusammensetzungen handelt es sich um sogenannte Hybridsysteme enthaltend radikalisch und kationisch photopolymerisierbare Komponenten. Neben der flüssigen radikalisch polymerisierbaren Komponente enthalten diese Zusammensetzungen zumindest:
(A) 40 bis 80 Gewichtsprozent eines flüssigen difunktionellen oder höherfunktionellen Epoxidharzes oder eines flüssigen Gemisches bestehend aus difunktionellen oder höherfunktionellen Epoxidharzen;
(B) 0,1 bis 10 Gewichtsprozent eines kationischen Photoinitiators oder eines Gemisches kationischer Photoinitiatoren: und
(C) 0,1 bis 10 Gewichtsprozent eines radikalischen Photoinitiators oder eines Gemisches radikalischer Photoinitatoren: und
(D) bis zu 40 Gewichtsprozent einer bestimmten Hydroxylverbindung.

Diese Hydroxylkomponente (D) ist ausgewählt aus der Gruppe bestehend aus OH-terminierten Polyethern, Polyestern und Polyurethanen und ist in den Zusammensetzungen in einer Menge von mindestens 5 Gewichtsprozent enthalten; die radikalisch polymerisierbare Komponente der genannten Zusammensetzungen enthält ausserdem folgende Bestandteile:
(E) 0 bis 15 Gewichtsprozent mindestens eines flüssigen Poly(meth-)acrylats mit einer (Meth-)Acrylatfunktionalität von grösser als 2, sowie
(F) 5 bis 40 Gewichtsprozent mindestens eines flüssigen cycloaliphatischen oder aromatischen Diacrylals.
wobei der Gehalt an Komponente (E) am gesamten (Meth-)acrylatgehalt höchstens 50 Gewichtsprozent beträgt.

Die genannten Stereolithographieharzzusammensetzungen führen allerdings zu Formkörpern, die noch eine relativ hohe Wasseraufnahme zeigen, was in manchen Fällen unerwünscht ist. Eine Aufgabe der vorliegenden Erfindung ist es daher. die genannten Hybridsysteme so zu verbessern, dass die Wasseraufnahme eines mit ihrer Hille hergestellten Formkörpers abnimmt. Hierbei sollen die übrigen für die Stereolithographie wichtigen Eigenschaften, wie z. B die oben schon genannten Eigenschaften, zumindest weitgehend erhalten bleiben.

Erfindungsgemäss wird diese Aufgabe dadurch gelost, dass eine flüssigestrahtüngshärtbare Zusammensetzung zur Verfügung gestellt wird. die neben einer flüssigen radikalisch polymerisierbaren Komponente zumindest die folgenden weiteren Komponenten enthält:
(A) 40 bis 80 Gewichtsprozent eines flüssigen difunktionellen oder höherfunktionellen aliphatischen oder cycloaliphatischen Epoxidharzes oder eines flüssigen Gemisches bestehend aus difunktionellen oder höherfunktionellen aliphatischen oder cycloaliphatischen Epoxidharzen;
(B) 0,1 bis 10 Gewichtsprozent eines kationischen Photoinitiators oder eines Gemisches kationischer Photoinitiatoren; und
(C) 0,1 bis 10 Gewichtsprozent eines radikalischen Photoinitiators oder eines Gemisches radikalischer Photoinitatoren; und
(D) bis zu 40 Gewichtsprozent einer spezifischen Hydroxylverbindung,
   dadurch gekennzeichnet ist, dass
   die Komponente (D) ausgewählt ist aus der Gruppe bestehend aus:
   (D1) phenolischen Verbindungen mit mindestens 2 Hydroxylgruppen,
   (D2) phenolischen Verbindungen mit mindestens 2 Hydroxylgruppen, die mit Ethylenoxid, Propylenoxid oder mit Ethylenoxid und Propylenoxid umgesetzt sind,
   (D3) Trimethylolpropan, Glycerin, Ricinusöl (Kastoröl) und den Verbindungen der Formel (D-III) und (D-IV):

      [HO]_{zD}-R_{5D} (D-III),

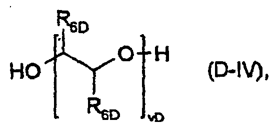

      worin R_{5D} ein unverzweigter oder verzweigter (zD)-wertiger C₂-C₂₀Alkanrest, R_{6D} alle unabhängig voneinander jeweils ein Wasserstoffatom oder eine Methylgruppe
      zD eine ganze Zahl von 1 bis 4 und
      vD eine ganze Zahl von 2 bis 20 bedeuten, und
   (D4) einem Gemisch aus mindestens 2 der unter (D1) bis (D3) genannten Verbindungen,
   und in den Zusammensetzungen in einer Menge von mindestens 2 Gewichtsprozent enthalten ist, die radikalisch polymerisierbare Komponente zumindest
(E) 4 bis 30 Gewichtsprozent mindestens eines flüssigen Poly(meth-)acrylats mit einer (Meth-)Acrylatfunktionalität von grösser als 2 enthält, und
die Komponente (D) Substanzen enthält, die aromatische Kohlenstoffringe in ihrem Molekül aufweisen.

Als eine fakultative weitere Komponente kann die erfindungsgemässe Zusammensetzung insbesondere noch (F) ein oder mehrere Di(meth-)acrylate enthalten, bevorzugt in einer Menge von 5 bis 40 Gewichtsprozent.

Bei den Epoxyharzen, die in den erfindungsgemässen Zusammensetzungen Verwendung finden können, handelt es sich zweckmässigerweise um bei Raumtemperatur flüssige Harze, die im Durchschnitt mehr als eine Epoxidgruppe (Oxiranring) im Molekül besitzen. Solche Harze können eine aliphatische, oder cycloaliphatische, Struktur haben; sie enthalten Epoxidgruppen als Seitengruppen, oder diese Gruppen bilden einen Teil eines alicyclischen oder heterocyclischen Ringsystems. Epoxyharze dieser Typen sind allgemein bekannt und im Handel erhältlich.

Polygiycidyl- und Poly-(β-methylglycidyl)-ester sind ein Beispiel für geeignete Epoxidharze. Sie sind erhältlich durch Umsetzung einer Verbindung mit mindestens zwei Carboxylgruppen im Molekül und Epichlorhydrin bzw. Glycerindichlorhydrin bzw. β-Methyl-epichlorhydrin. Die Umsetzung erfolgt zweckmässig in Gegenwart von Basen. Als Verbindungen mit mindestens zwei Carboxylgruppen im Molekül können hierbei z. B. aliphatische Polycarbonsäuren verwendet werden, wie Glutarsäure, Adipinsäure, Pimelinsäure, Korksäure, Azelainsäure, Sebazinsäure oder dimerisierte bzw. trimerisierte Linolsäure. Genauso können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.

Polyglycidyl-oder Poly-(β-methylglycidyl)-ether erhältlich durch Umsetzung einer Verbindung mit mindestens zwei freien alkoholischen Hydroxygruppen und einem geeignet substituierten Epichlorhydrin unter alkalischen Bedingungen oder in Anwesenheit eines sauren Katalysators und anschliessender Alkalibehandlung können ebenfalls verwendet werden. Ether dieses Typs leiten sich beispielsweise ab von acyclischen Alkoholen, wie Ethylenglykol, Diethylenglykol und höheren Poly-(oxyethylen)-glykolen, Propan-1,2-diol, oder Poly-(oxypropylen)-glykolen, Propan-1,3-diol, Butan-1,4-diol, Poly-(oxytetramethylen)-glykolen, Pentan-1,5-diol, Hexan-1,6-diol, Hexan-2,4,6-triol, Glycerin, 1,1,1-Trimethylolpropan, Bistrimethylolpropan, Pentaerylhrit, Sorbit, sowie von Polyepichlorhydrinen. Geeignete Glycidylether sind aber auch aus cycloaliphatischen Alkoholen erhältlich, wie 1,3- oder 1,4-Dihydroxycyclohexan, Bis-(4-hydroxycyclohexyl)-methan, 2,2-Bis-(4-hydroxycyclohexyl)-propan oder 1,1-Bis-(hydroxymethyl)cyclohex-3-en.

Beispiele für Epoxidverbindungen, worin die Epoxidgruppen einen Teil eines alicyclischen oder heterocyclischen Ringsystems bilden, sind unter anderem Bis-(2,3-epoxicyclopentyl)-ether, 2,3-Epoxicyclopentylglycidylether, 1,2-Bis-(2,3-epoxicyclopentyloxy)-ethan, Bis-(4-hydroxycyclohexyl)-methandiglycidylether, 2,2-Bis-(4-hydroxycyclohexyl)-propandiglycidylether,. 3,4-Epoxycyclohexylmethyl-3,4-epoxycyclohexancarboxylat, 3.4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)hexandioat, Ethylenbis-(3,4-epoxycyclohexancarboxylat), Ethandioldi-(3,4-epoxycyclohexymethyl)-ether, Vinylcyclohexendioxid, Dicyclopentadiendiepoxid oder 2-(3,4-Epoxycyclohexyl-5,5-spiro-3,4-epoxy) cyclohexan-1,3-dioxan.

Es lassen sich aber auch Epoxyharze einsetzen, bel denen die 1,2-Epoxidgruppen an unterschiedliche funktionelle Gruppen gebunden sind.

Denkbar ist weiterhin der Einsatz flüssiger vorreagierter Addukte von Epoxyharzen, wie den oben genannten, mit Härtern für Epoxyharze.

Selbstverständlich können auch flüssige Mischungen von Epoxyharzen in den erfindungsgemässen Zusammensetzungen verwendet werden.

Als Komponente (B) der erfindungsgemässen Zusammensetzungen lassen sich eine Vielzahl bekannter und in der Technik erprobter kationischer Photoinitiatoren für Epoxyharze einsetzen. Dabei handelt es sich beispielsweise um Oniumsalze mit Anionen schwacher Nukleophilie. Beispiele dafür sind Haloniumsalze, lodosylsalze oder Sulfoniumsalze, wie sie in der EP-A-0 153 904 beschrieben sind, Sulfoxoniumsalze, wie beispielsweise in der EP-A-0 035 969, EP-A-0 044 274, EP-A-0 054 509 und der EP-A-0 164 314 beschrieben, oder Diazoniumsalze, wie beispielsweise in der US-A-3,708,296 beschrieben. Weitere kationische Photoinitiatoren sind Metallocensalze, wie bespielsweise in den EP-A-0 094 914 und der EP-A-0 094 915 beschrieben.

Eine Übersicht über weitere gängige Oniumsalzinitiatoren und/oder Metallocensalze bieten "UV-Curing, Science and Technology", (Editor: S.P. Pappas, Technology Marketing Corp., 642 Westover Road, Stanford, Conneticut, USA) oder "Chemistry & Technology of UV & EB Formulation for Coatings, Inks & Paints", Vol. 3 (edited by P. K. T. Oldring).

Bevorzugt sind Zusammensetzungen enthaltend als Komponente (B) eine Verbindung der Formeln (B-I), (B-II) oder (B-III) 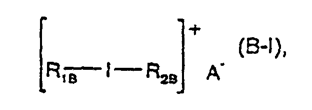 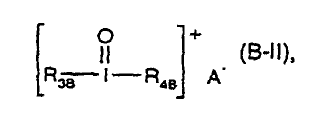 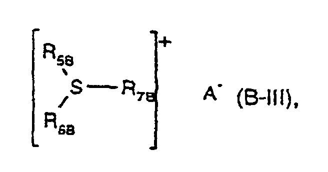 worin R_{1B}, R_{2B}, R_{3B}, R_{4B}, R_{5B}, R_{6B}, und R_{7B} unabhängig voneinander unsubstituiertes oder durch geeignete Reste substituiertes C₆-C₁₈-Aryl bedeuten, und
- A⁻: CF₃SO₃⁻ oder ein Anion der Formel [LQ_{mB}]⁻ bedeutet, worin
- L: Bor, Phosphor, Arsen oder Antimon darstellt,
- Q: ein Halogenatom ist oder ein Teil der Reste Q in einem Anion LQₘ⁻ auch Hydroxyl gruppen sein kann und
- mB: eine ganze Zahl ist, die der um 1 vergrösserten Wertigkeit von L entspricht.

Beispiele für C₆-C₁₈-Aryl sind hierbei Phenyl, Naphthyl, Anthryl und Phenanthryl. Gegebenenfalls vorliegende Substituenten für geeignete Reste sind Alkyl, bevorzugt C₁-C₆-Alkyl, wie Methyl, Ethyl, n-Propyl, Isopropyl, n-Butyl, sec-Butyl, Isobutyl, tert-Butyl oder die verschiedenen Pentyl- oder Hexyl-Isomare, Alkoxy, bevorzugt C₁-C₆-Alkoxy, wie Methoxy, Ethoxy, Propoxy, Butoxy, Pentoxy oder Hexoxy, Alkylthio, bevorzugt C₁-C₆-Alkylthio, wie Methylthio, Ethylthio, Propylthio, Butylthio, Pentylthio oder Hexylthio, Halogen, wie Fluor, Chlor, Brom oder Jod, Aminogruppen, Cyanogruppen, Nitrogruppen oder Arylthio, wie Phenylthio. Beispiele für bevorzugte Halogenatome Q sind Chlor und insbesondere Fluor. Bevorzugte Anionen LQ_{mB} sind BF₄⁻, PF₆-, AsF₆⁻, Sbf₆⁻ und SbF₅(OH)⁻.

Besonders bevorzugt sind Zusammensetzungen enthaltend als Komponente (B) eine Verbindung der Formel (B-III), worin R_{5B}, R_{6B} und R_{7B} Aryl sind, wobei Aryl vor allem Phenyl oder Biphenyl oder Gemische dieser beiden Gruppen bedeutet.

Weiterhin bevorzugt sind Zusammensetzungen enthaltend als Komponente (B) eine Verbindung der Formel (B-IV) 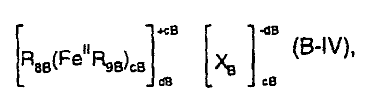 worin
- cB: 1 oder 2 bedeutet,
- dB: 1, 2, 3, 4 oder 5 ist,
- X_{B}: für ein nicht nukleophiles Anion, insbesondere PF₆-, AsF₆-, SbF₆-, CF₃SO₃⁻, C₂F₅SO₃⁻, n-C₃F₇SO₃⁻, n-C₄F₉SO₃⁻, n-C₆F₁₃SO₃⁻ und n-C₈F₁₇SO₃⁻ steht,
- R_{8B}: ein p-Aren ist und
- R_{9B}: ein Anion eines p-Arens, insbesondere ein Cyclopentadienylanion, bedeutet.

Beispiele für p-Arene als R_{8B} und Anionen von p-Arenen R_{9B} als findet man in der EP-A-0 094 915. Beispiele für bevorzugte p-Arene als R_{8B} sind Toluol, Xylol, Ethylbenzol, Cumol, Methoxybenzol, Methylnaphthalin, Pyren, Perylen, Stilben, Diphenylenoxid und Diphenylensulfid. Insbesondere bevorzugt sind Cumol, Methylnaphthalin oder Stilben. Beispiele für nicht nukleophile Anionen X⁻ sind FSO₃-, Anionen von organischen Sulfonsäuren, von Carbonsäuren oder von Anionen LQ_{mB}⁻. Bevorzugte Anionen leiten sich ab von teiffluor- oder perfluoraliphatischen oder teilfluor- oder perfluoraromatischen Carbonsäuren, wie CF₃SO₃⁻, C₂F₅SO₃⁻, n-C₃F₇SO₃⁻, n-C₄F₉SO₃⁻, n-C₆F₁₃SO₃⁻, n-C₈F₁₇SO₃⁻, oder insbesondere von teilfluor- oder perfluoraliphatischen oder teilfluor- oder perfluoraromatischen organischen Sulfonsäuren, z. B. von C₆F₅SO₃⁻, oder es handelt sich bevorzugt um Anionen LQ_{mB}⁻, wie BF₄⁻, PF₆⁻ AsF₆⁻, SbF₆⁻, SbF₅(OH)⁻. Bevorzugt sind PF₆⁻, AsF₆⁻, SbF₆-, CF₃SO₃⁻, C₂F₅SO₃⁻, n-C₃F₇SO₃⁻, n-C₄F₉SO₃⁻, n-C₆F₁₃SO₃⁻ und n-C₈F₁₇SO₃⁻.

Die Metallocensalze können auch in Kombination mit Oxidationsmitteln eingesetzt werden. Solche Kombinationen sind in der EP-A-0 126 712 beschrieben.

Zur Erhöhung der Lichtausbeute können je nach Initiatortyp auch Sensibilisatoren eingesetzt werden. Beispiele hierfür sind polycyclische aromatische Kohlenwasserstoffe oder aromatische Ketoverbindungen. Spezifische Beispiele bevorzugter Sensibilisatoren sind in der EP-A-0 153 904 erwähnt.

In den erfindungsgemässen Zusammensetzungen können als Komponente (C) alle Typen von Photoinitiatoren eingesetzt werden, welche bei der entsprechenden Bestrahlung freie Radikale bilden. Typische Vertreter radikalischer Photoinitiatoren sind Benzoine, wie Benzoin, Benzoinether, wie Benzoinmethylether, Benzoinethylether und Benzoinisopropylether, Benzoinphenylether und Benzoinacetat, Acetophenone, wie Acetophenon, 2,2-Dimethoxyacetophenon und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert-Butylanthrachinon, 1-Chloranthrachinon und 2-Amylanthrachinon, ferner Triphenylphosphin, Benzoylphosphinoxide, wie beispielsweise 2,4,6-Trimethylbenzoyldiphenylphosphinoxid (Luzirin®TPO), Bis-acylphosphonoxide, Benzophenone, wie Benzophenon und 4,4'-Bis-(N,N'-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenyiketon, Phenyl-(1-hydroxyisopropyl)-keton und 4-Isopropylphenyl-(1-hydroxyisopropyl)-keton, welche alle bekannte Verbindungen darstellen.

Besonders geeignete radikalische Photoinitiatoren, welche gewöhnlich in Kombination mit einem He/Cd-Laser als Lichtquelle verwendet werden, sind Acetophenone, wie 2,2-Dialkoxybenzophenone und 1-Hydroxyphenylketone, beispielsweise 1-Hydroxycyclohexylphenylketon oder 2-Hydroxyisopropylphenylketon (= 2-Hydroxy-2.2-dimethylacetophenon), insbesondere aber 1-Hydroxycyclohexylphenylketon.

Eine Klasse von Photoinitiatoren (C), die gewöhnlich bei Verwendung von Argonion-Lasern eingesetzt wird, sind die Benzilketale, wie beispielsweise Benzildimethylketal. Insbesondere verwendet man als Photoinitiator ein a-Hydroxyphenylketon, Benzildimethylketal oder 2,4,6-Trimethylbenzoyldiphenylphosphinoxid.

Eine weitere Klasse von geeigneten Photoinitiatoren (C) stellen die ionischen Farbstoff-Gegenionverbindungen (ionic dye-counter ion compound) dar, welche in der Lage sind, aktinische Strahlen zu absorbieren und freie Radikale zu erzeugen, die die Polymerisation der Acrylate initiieren können. Die erfindungsgemässen Zusammensetzungen, welche ionische Farbstoff-Gegenionverbindungen enthalten, können auf diese Weise variabler mit sichtbarem Licht im einstellbaren Wellenlängenbereich von 400-700 nm gehärtet werden. Ionische Farbstoff-Gegenionverbindungen und deren Wirkungsweise sind bekannt, beispielsweise aus der EP-A-0 223 587 und den US-Patenten 4,751,102, 4,772,530 und 4,772,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der folgenden Formel 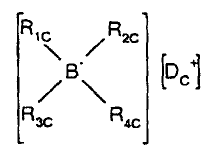 worin D_{c}⁺ für einen kationischen Farbstoff steht und R_{1C}, R_{2C}, R_{3C} und R_{4C} unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten. Bevorzugte Definitionen für die Reste Ric bis R4c können beispielsweise aus EP-A-0 223 587 entnommen werden.

Vorzugsweise enthalten die erfindungsgemässen Zusammensetzungen als Photoinitiator (C) ein 1-Hydroxyphenylketon, insbesondere 1-Hydroxycyclohexylphenylketon.

Die Photoinitiatoren (B) und (C) werden in wirksamen Mengen zugesetzt, das heisst, in Mengen von 0,1 bis 10, insbesondere von 0,5 bis 5 Gewichtsprozent, bezogen auf die Gesamtmenge der Zusammensetzung. Wenn die erfindungsgemässen Zusammensetzungen für stereolithographische Verfahren verwendet werden, wobei normalerweise Laserstrahlen eingesetzt werden, ist es wesentlich, dass die Absorptionsfähigkeit der Zusammensetzung durch Typ und Konzentration der Photoinitiatoren so abgestimmt wird, dass die Härtungstiefe bei normaler Lasergeschwindigkeit ungefähr 0,1 bis 2,5 mm beträgt. Bevorzugt liegt die Gesamtmenge an Photoinitiatoren in den erfindungsgemässen Zusammensetzungen zwischen 0,5 und 6 Gewichtsprozent.

Die erfindungsgemässen Gemische können auch verschiedene Photoinitiatoren enthalten, welchegegenüber Strahlen von Emissionslinien unterschiedlicher Wellenlängen verschieden empfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Bevorzugt enthalten die erfindungsgemässen Zusammensetzungen die Komponente (D) in einer Menge von mindestens 5, insbesondere von mindestens 10 Gewichtsprozent, bezogen auf die Gesamtmenge der Komponenten (A), (B), (C), (D) und (E).

Die Komponente (D) der erfindungsgemässen Zusammensetzungen ist vorzugsweise aus der Gruppe bestehend aus
(D1) den Dihydroxybenzolen, Trihydroxybenzolen und den Verbindungen der Formel (D-1): 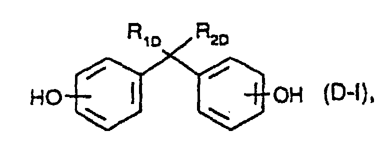 worin
- R_{1D} und R_{2D}: ein Wasserstotfatom oder eine Methylgruppe bedeuten; und
- (D2): den Verbindungen der Formel (DII): 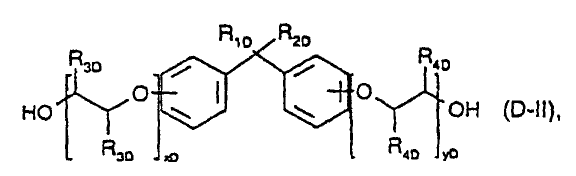 worin
B_{1D} und R_{2D} jeweils ein Wasserstoffatom oder eine Methylgruppe;
R_{3D} und R_{4D} alle unabhängig voneinander ein Wasserstoffatom oder eine Methylgruppe und
xD sowie yD jeweils eine ganze Zahl von 1 bis 15 bedeuten;

Vorzugsweise handelt es sich bei den Verbindungen der obigen Formeln (D-I), (D-II), um die jeweiligen 1,4-Derivate beziehungsweise Bis-1,4-Derivate.

Die Verbindungen der Formeln (D-I) und D-II und Methoden zu ihrer Herstellung sind dem Fachmann bekannt.

Bevorzugt besteht die Komponente (D) der erfindungsgemässen Zusammensetzungen aus (D2) phenolischen Verbindungen mit mindestens 2 Hydroxylgruppen, die mit Ethylenoxid, Propylenoxid oder mit Ethylenoxid und Propylenoxid umgesetzt sind, insbesondere aus den Verbindungen der Formel (D-IIa): 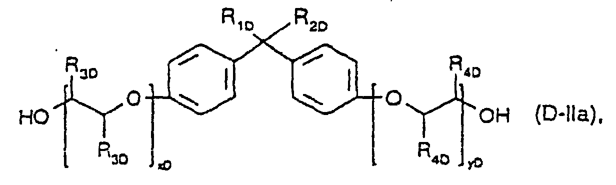 worin
R_{1D} und P_{2D} beide ein Wasserstoffatom oder beide eine Methylgruppe:
R_{3D} und R_{4D} alle unabhängig voneinander jeweils ein Wasserstoffatom oder eine Methylgruppe und
xD sowie yD jeweils eine ganze Zahl von 1 bis 15 bedeuten.

Die in den erfindungsgemässen Zusammensetzungen als Komponente (E) verwendeten flüssigen Poly(meth-)acrylate mit einer (Meth-)Acrylatfunktionalität von grösser als zwei können beispielsweise tri-, tetra- oder pentafunktionelle monomere oder oligomere aliphatische, cycloaliphatische oder aromatische Acrylate oder Methacrylate sein. Die Verbindungen weisen bevorzugt ein Molekulargewicht von 200 bis 500 auf.

Als aliphatische polyfunktionelle (Meth-)acrylate eignen sich beispielsweise die Triacrylate und Trimethacrylate von Hexan-2,4,6-triol, Glycerin oder 1,1,1-Trimethylolpropan, ethoxyliertes oder propoxyliertes Glycerin oder 1,1,1-Trimethylolpropan und die hydroxygruppenhaltigen Tri(meth-)acrylate, die durch Umsetzung von Triepoxidverbindungen, wie beispielsweise die Triglycidylether von den genannten Triolen, mit (Meth-)acrylsäure erhalten werden. Weiterhin können zum Beispiel Pentaerythritoltetraacrylat, Bistrimethylolpropantetraacrylat, Pentaerythritolmonohydroxytriacrylat oder -methacrylat oder Dipentaerythritolmonohydroxypentaacrylat oder -methacrylat verwendet werden.

Ausserdem können z. B. polyfunktionelle Urethanacrylate oder Urethanmethacrylate verwendet werden. Diese Urethan(meth-)acrylate sind dem Fachmann bekannt und können in bekannter Weise hergestellt werden, indem man beispielsweise ein hydroxylterminiertes Polyurethan mit Acrylsäure oder Methacrylsäure umsetzt, oder indem man ein isocyanatterminiertes Präpolymer mit Hydroxyalkyl(meth-)acrylaten zum Urethan(meth-)acrylat umsetzt.

Als aromatische Tri(meth-)acrylate eignen sich beispielsweise die Umsetzungsprodukte aus Triglycidylethem dreiwertiger Phenole und drei Hydroxylgruppen aufweisende Phenol- oder Kresolnovolake mit (Meth)-acrylsäure.

Die als Komponente (E) eingesetzten (Meth-)acrylate stellen bekannte Verbindungen dar und sind zum Teil im Handel erhältlich, beispielsweise von der Firma SARTOMER Company unter Produktebezeichnungen wie SR®295, Sol®350, SR®351, SR®367, SR®399, SR®444, SR®454 oder SR®9041.

Bevorzugt sind Zusammensetzungen, worin die Komponente(E) ein Tri(meth-)acrylat oder ein Penta(meth-) acrylat ist.

Für die Di(meth-)acrylatkomponente (F) eignen sich beispielsweise die Di(meth-)acrylate von cycloaliphatischen oder aromatischen Diolen, wie 1,4-Dihydroxymethylcyclohexan, 2,2-Bis-(4-hydroxycyclohexyl)-propan, Bis-(4-hydroxycyclohexyl)-methan, Hydrochinon, 4,4'-Dihydroxybiphenyl, Bisphenol A, Bisphenol F, Bisphenol S, ethoxyliertes oder propoxyliertes Bisphenol A, ethoxyliertes oder propoxyliertes Bisphenol F oder ethoxyliertes oder propoxyliertes Bisphenol S. Solche Di(meth-)acrylate sind bekannt und zum Teil im Handel erhältlich.

Als Di(meth-)acrylate können auch Verbindungen der Formeln (F-I), (F-II), (F-III) oder (F-IV) 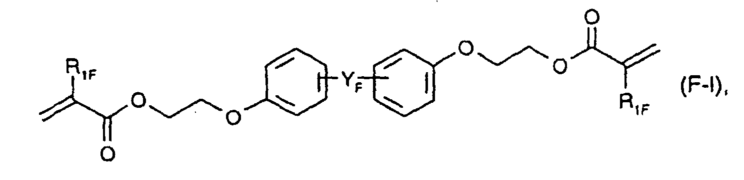 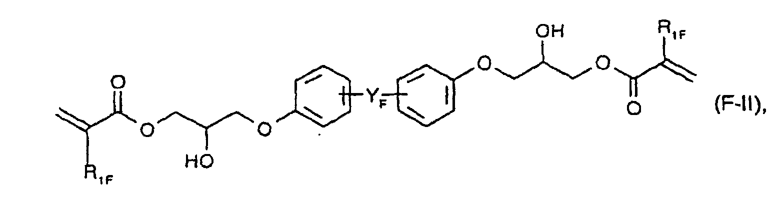 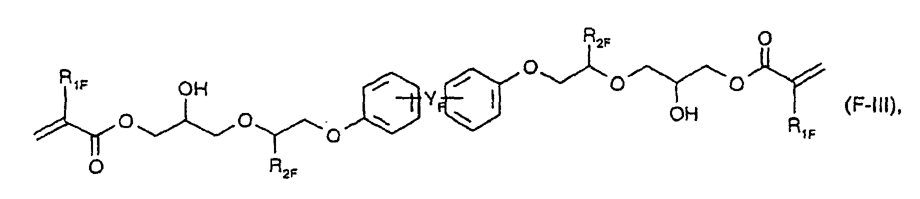 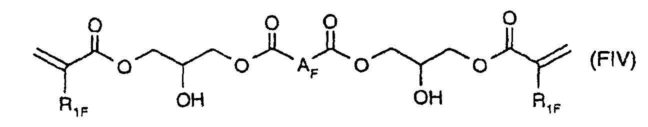 eingesetzt werden, worin
- R_{1F}: ein Wasserstoffatom oder Methyl bedeutet,
- Y_{F}: für eine direkte Bindung, C₁-C₆-Alkylen, -S-, -O-, -SO-, -SO₂- oder -CO- steht,
- R_{2F}: für eine C₁-C₈-Alkylgruppe, eine unsubstituierte oder durch eine oder mehrere C₁-C₄-Alkylgruppen, Hydroxygruppen oder Halogenatome substituierte Phenylgruppe, oder für einen Rest der Formel -CH₂-OR_{3F} steht, worin
- R_{3F}: eine C₁-C₈-Alkytgruppe oder Phenylgruppe bedeutet und
- A_{F}: einen Rest ausgewählt aus den Resten der Formeln 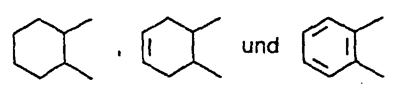 darstellt.

Ferner können als Di(meth-)acrylate beispielsweise auch Verbindungen der Formeln (F-V), (F-VI), (F-VII) oder (F-VIII) 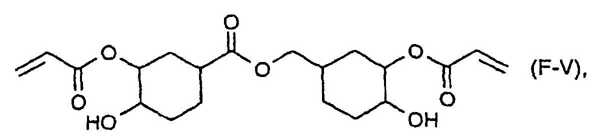 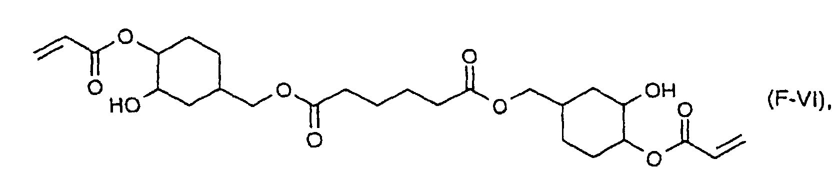 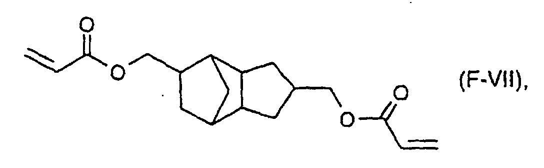 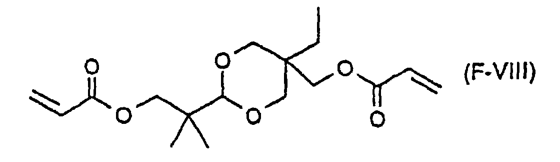 verwendet werden. Diese Verbindungen der Formel (F-I) bis (F-VIII) sind bekannt und zum Teil im Handel erhältlich. Ihre Herstellung ist weiterhin in der EP-A-0 646 580 beschrieben.

Oft ist es auch zweckmässig, den erfindungsgemässen Zusammensetzungen weitere Bestandteile zuzsetzen, z. B. übliche Additive, wie Reaktivverdünner, z. B. Propylencarbonat, Propylencarbonatpropenylether oder Lactone, Stabilisatoren, z. B. UV-Stabilisatoren, Polymerisationsinhibitoren, Trennmittel, Benetzungsmittel, Verlaufsmittel, Sensibilisatoren, Antiabsetzmittel, oberflächenaktive Mittel, Farbstoffe, Pigmente oder Füllstoffe. Diese werden jeweils in einer für den erwünschten Zweck wirksamen Menge eingesetzt und machen bevorzugt insgesamt bis zu 20 Gewichtsprozent der erfindungsgemässen Zusammensetzungen aus. Insbesondere Füllstoffe können aber auch in grösseren Mengen noch sinnvoll sein, z. B. in Mengen bis zu 75 Gewichtsprozent.

Die erfindungsgemässen Zusammensetzungen können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, in Abwesenheit von Licht und gegebenenfalls bei leicht erhöhter Temperatur.

Die erfindungsgemässen Zusammensetzungen können durch Bestrahlen mit aktinischem Licht, beispielsweise mittels Elektronen-, Röntgenstrahlen, UV- oder VIS-Licht, vorzugsweise mit Strahlen im Wellenlängenbereich von 280-650 nm polymerisiert werden. Besonders geeignet sind Laserstrahlen von HeCd, Argon oder Stickstoff sowie Metalldampf- und NdYAG-Laser. Es ist dem Fachmann bekannt, dass für jede gewählte Lichtquelle der geeignete Photoinitiator ausgewählt und gegebenenfalls sensibilisiert werden muss. Man hat erkannt, dass die Eindringtiefe der Strahlen in die zu polymerisierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche die höchste Anzahl von entstehenden freien Radikalen beziehungsweise kationischen Partikeln bewirken und die grösste Strahlungseindringtiefe in die zu polymerisierenden Zusammensetzungen ermöglichen.

Einen weiteren Gegenstand der Erfindung bildet ein Verfahren zur Herstellung eines gehärteten Produkts, bei dem man Zusammensetzungen, wie sie oben beschrieben sind, mit aktinischer Strahlung behandelt. Beispielsweise können die erfindungsgemässen Zusammensetzungen hierbei als Klebstoffe, als Beschichtungsmittel, als Photoresists, z. B. als Lötstoppresist, oder für das Rapid-Prototyping, insbesondere jedoch für die Stereolithographie verwendet werden. Werden die erfindungsgemässen Gemische als Beschichtungsmittel eingesetzt, so erhält man klare und harte Beschichtungen auf Holz, Papier, Metall, Keramik oder anderen Oberflächen. Die Beschichtungsdicke kann dabei sehr variieren und etwa von 0,01 mm bis etwa 1 mm betragen. Aus den erfindungsgemässen Gemischen können Reliefbilder für gedruckte Schaltungen oder Druckplatten direkt durch Bestrahlen der Gemische hergestellt werden, beispielsweise mittels eines computergesteuerten Laserstrahls geeigneter Wellenlänge oder unter Anwendung einer Photomaske und einer entsprechenden Lichtquelle.

Eine spezielle Ausführungsform des vorgenannten Verfahrens ist ein Verfahren zur stereolithographischen Herstellung eines dreidimensionalen Formkörpers, bei dem man den Körper aus einer erfindungsgemässen Zusammensetzung mit Hilfe einer sich wiederholenden abwechselnden Abfolge von Verfahrensschritten (a) und (b) aufbaut, wobei in Schritt (a) eine Schicht der Zusammensetzung, deren eine Begrenzung die Oberfläche der Zusammensetzung ist, mit Hilfe von geeigneter Strahlung innerhalb eines Flächenbereiches gehärtet wird, der der gewünschten Querschnittsfläche des zu bildenden dreidimensionalen Körpers in der Höhe dieser Schicht entspricht, in Schritt (b) die frisch gehärtete Schicht mit einer neuen Schicht der flüssigen, strahlungshärtbaren Zusammensetzung überschichtet wird, diese Abfolge der Schritte (a) und (b) solange wiederholt wird, bis ein Körper mit der gewünschten Form gebildet ist. Bei diesem Verfahren wird als Strahlungsquelle vorzugsweise ein Laserstrahl verwendet, der besonders bevorzugt computergesteuert ist.

Im allgemeinen erfolgt weiterhin nach der oben beschriebenen ersten Strahlungshärtung, bei der die sogenannten Grünlinge erhalten werden, die noch keine ausreichende Festigkeit zeigen, die endgültige Aushärtung der Formkörper durch Erhitzen und/oder weiteres Bestrahlen.

Der Ausdruck "flüssig" ist in dieser Anmeldung mit "bei Raumtemperatur flüssig" gleichzusetzen, wenn nichts anderes gesagt ist, wobei unter Raumtemperatur im allgemeinen eine Temperatur zwischen 5° und 40 °C, bevorzugt zwischen 10° und 30 °C, zu verstehen ist.

### Beispiele:

Die in den nachfolgenden Beispielen angegebenen Handelsnamen der Komponenten entsprechen den aus der nachfolgenden Tabelle entnehmbaren chemischen Substanzen.

| | |
|---|---|
| Handelsname | Chemische Bezeichnung |
| Araldit CY 179 | 3,4-Epoxycyclohexylmethyl-3',4'-epoxycyclohexancarboxylat |
| Araldit DY 026 | Butandiol-diglycidylether |
| Araldit DY 0395 | Trimethylolpropantriglycidylether |
| Araldit DY 0396 | Cyclohexandimethanoldiglycidylether |
| Cyracure UVI 6974 | Gemisch aus (C₆H₅)S(C₆H₄)-S⁺(C₆H₅)₂SbF₆⁻ und F₆Sb⁻(C₆H₅)₂S⁺-(C₆H₄)S(C₆H₄)-S⁺(C₆H₅)₂SbF₆⁻ |
| lrgacure 184 | 1-Hydroxycyclohexylphenylketon |
| Dianol 320 | Propoxyliertes Bisphenol A |
| Dianol 2211 | Ethoxyliertes Bisphenol A |
| Sariomer SR 399 Sartomer SR 9041 | Dipentaerythritolmonohydroxypentaacrylat |
| Novacure 3700 | Bisphenol-A-diglycidyletherdiacrylat |

Die in den Beispielen angegebenen Formulierungen werden hergestellt, indem die Komponenten mit einem Rührer bei 60°C so lange vermischt werden, bis eine homogene Zusammensetzung erhalten wird. Die physikalischen Daten für die Formulierungen werden wie folgt erhalten:

Die Viskosität der flüssigen Mischung wird bei 30°C mit einem Brookfield -Viskosimeter bestimmt.

Die mechanischen Eigenschaften der Formulierungen werden an dreidimensionalen Körpern bestimmt, die mit Hilfe eines He/Cd- oder Ar/UV-Lasers hergestellt werden.

Die Photoempfindlichkeit der Formulierungen wird an sog. "Window-panes" bestimmt. Dabei werden einschichtige Probekörper mit verschiedenen Laserenergien hergestellt und die erhaltenen Schichtdicken gemessen. Die graphische Darstellung der erhaltenen Schichtdicke gegen den Logarithmus der eingestrahlten Energie ergibt eine Gerade ("working curve"). Die Steigung dieser Gerade wird als Dp (Angabe in mm oder mils) bezeichnet. Die Energie, bei der die Gerade die x-Achse schneidet, wird als Ec bezeichnet (die Energie, bei der gerade noch eine Gelierung des Materials stattfindet, vgl. P. Jacobs, Rapid Prototyping and Manufacturing, Soc. of Manufacturing Engineers, 1992, S. 270 ff.)

Die Grünfestigkeit wird durch Messung des Biegemoduls (flexural modulus) 10 min. und 1 Stunde nach Herstellung des Prüfkörpers gemessen (ASTM D 790). Der Biegemodul nach der Aushärtung wird nach 1-stündiger Härtung des Prüfkörpers im UV-Licht bestimmt.

Der Curl-Faktor (CF) wird in der Stereolithographie gebraucht, um die Schrumpfeigenschaften von verschiedenen Formulierungen miteinander zu vergleichen (vgl. P. Jacobs, Rapid Prototyping and Manufacturing, Soc. of Manufacturing Engineers, 1992, S. 256ff.). Die in dieser Anmeldung angegebenen Curl-Faktoren (in %) werden an Probekörpern bestimmt, die mit dem Baustil "ACES" (vgl. P.Jacobs, Stereolithography and other RP&MTechnologies, Soc. of Manufacturing Engineers, 1996, S. 156 ff.) mit einer Schichtdicke von 0,15 mm (6 mils) hergestellt werden.

Zur Bestimmung der Wasseraufnahme werden Probekörper mit dem Baustil "Quick Cast" (vgl. P. Jacobs, Stereolithography and other RP&M Technologies, 1996, S. 183ff.) hergestellt und nach vollständiger Aushärtung (60 min im UV-Licht, 30 min bei 100°C) im Exsiccator bis zur Gewichtskonstanz getrocknet. Dann werden die Proben bei 62 bzw. 88% Luftfeuchtigkeit gelagert. Die Wasseraufnahme wird durch Wägen der Proben in regelmässigen Abständen bestimmt, bis Gewichtskonstanz erreicht ist, was i. a. spätestens nach 7-14 Tagen der Fall ist. In den vorliegenden Beispielen ist die Wasseraufnahme nach 14 Tagen angegeben.

### Beispiel 1:

a) Aus den folgenden Komponenten wird in der oben angegebenen Weise eine homogene flüssige Zusammensetzung hergestellt:

| | |
|---|---|
| 14.6 g | Araldit DY 0395 |
| 42.5 g | Araldit CY 179 |
| 6,0 g | Novacure 3700 |
| 6,0 g | Sartomer 399 |
| 24,9 g | Dianol 320 |
| 2,0g | Irgacure 184 |
| 4,0 g | Cyracure UVI 6974 |

Die Viskosität dieser Mischung beträgt 800 mPa s (cps) bei 30°C.
Die Steigung der "working curve" beträgt 0,124 mm (4,9 mils), die kritische Energie Ec beträgt 12,5 mJ/cm².
Der Biegemodul des Grünlings beträgt eine Stunde nach Herstellung in der Stereolithgraphieanlage 61 MPa, nach vollständiger Aushärtung 2360 Mpa.
Der Curl-Faktor beträgt 8,5%.
Die Wasseraufnahme eines Quick-Cast Probekörpers nach 14 Tagen bei 62% rel. Luftfeuchtigkeit ist 2,1% und 4,4% nach 14 Tagen bei 88% Luftfeuchtigkeit.
b) Eine Zusammensetzung enthaltend die folgenden Bestandteile:

| | |
|---|---|
| 20,0 g | Araldit DY 0395 |
| 15,0 g | Araldit DY 0396 |
| 34,0 g | Araldit CY 179 |
| 6,0 g | Bisphenol-A-diglycidyldiacrylat |
| 6,0 g | Sartomer 9041 |
| 13,5 g | Dianol 320 |
| 1,5 g | Irgacure 184 |
| 4,0 g | Cyracure UVI 6974 |

zeigt vergleichbare Eigenschaften wie die unter a) beschriebenen Zusammensetzung.

Beispiele 2-8: Es werden weitere erfindungsgemässe Gemische in der oben beschriebenen Art hergestellt. Ihre Zusammensetzung und ihre physikalische Eigenschaften können der nachstehenden Tabelle entnommen werden.

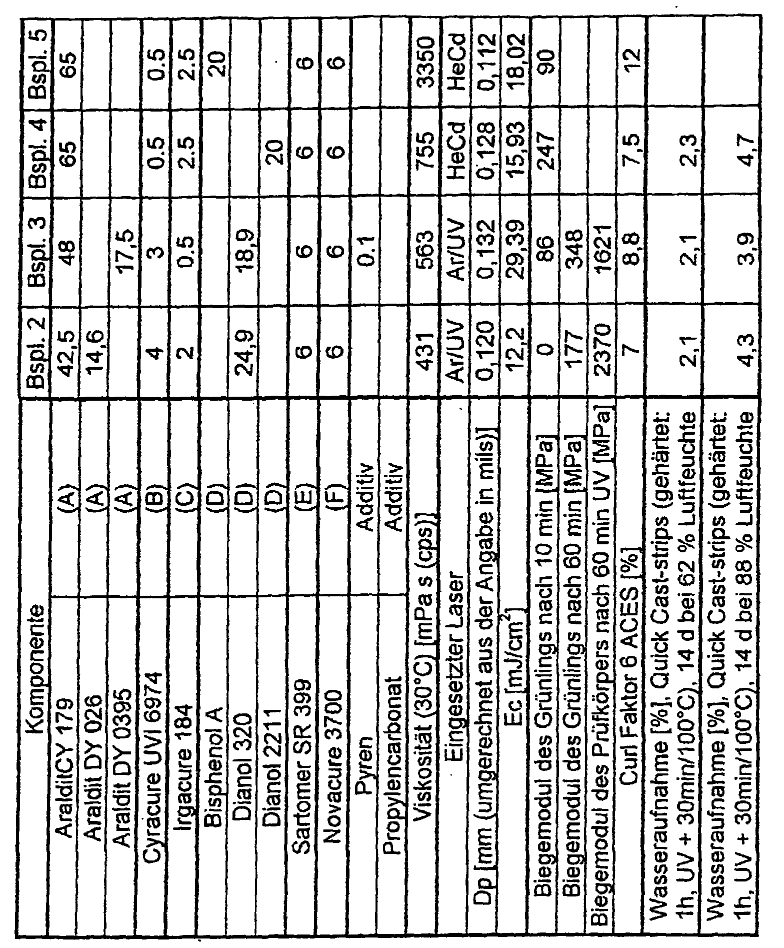

## Patentansprüche

1. Flüssige, strahlungshärtbare Zusammensetzung, die neben einer flüssigen, radikalisch polymerisierbaren Komponente zumindest die folgenden weiteren Komponenten enthält:
(A) 40 bis 80 Gewichtsprozent eines flüssigen difunktionellen oder höherfunktionellenaliphatischen oder cycloaliphatischen Epoxidharzes oder eines flüssigen Gemisches bestehend aus difunktionellen oder höherfunktionellen aliphatischen oder cycloaliphatischen Epoxidharzen;
(B) 0,1 bis 10 Gewichtsprozent eines kationischen Photoinitiators oder eines Gemisches kationischer Photoinitiatoren; und
(C) 0,1 bis 10 Gewichtsprozent eines radikalischen Photoinitiators oder eines Gemisches radikalischer Photoinitatoren; und
(D) bis zu 40 Gewichtsprozent einer spezifischen Hydroxylverbindung,
**dadurch gekennzeichnet ist, dass**
die Komponente (D) ausgewählt ist aus der Gruppe bestehend aus:
(D1) phenolischen Verbindungen mit mindestens 2 Hydroxylgruppen,
(D2) phenolischen Verbindungen mit mindestens 2 Hydroxylgruppen, die mit Ethylenoxid, Propylenoxid oder mit Ethylenoxid und Propylenoxid umgesetzt sind,
(D3) Trimathylolpropan, Glycerin, Ricinusöl (Kastoröl) und den Verbindungen der Formel (D-III) und (D-IV):
[HO]_{zD}-R_{5D} (D-III), 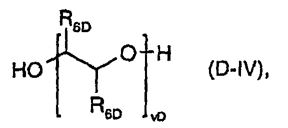
worin R_{5D} ein unverzweigter oder verzweigter (zD)-wertiger C₂-C₂₀Alkanrest,
R₆₀ alle unabhängig voneinander jeweils ein Wasserstoffatom oder eine Methylgruppe
zD eine ganze Zahl von 1 bis 4 und
vD eine ganze Zahl von 2 bis 20 bedeuten, und
(D4) einem Gemisch aus mindestens 2 der unter (D1) bis (D3) genannten Verbindungen,
und in den Zusammensetzungen in einer Menge von mindestens 2 Gewichtsprozent enthalten ist, die radikalisch polymerisierbare Komponente zumindest
(E) 4 bis 30 Gewichtsprozent mindestens eines flüssigen Poly(meth-)acrylats mit einer (Meth-)Acrylatfunktionalität von grösser als 2 enthält, und
die Komponente (D) Substanzen enthält, die aromatische Kohlenstoffringe in ihrem Molekül aufweisen.

2. Zusammensetzung nach Anspruch 1, die mindestens 5 Gewichtsprozent der Komponente (D) enthält.

3. Zusammensetzung nach einem der Ansprüche 1 oder 2, bei der die Komponente
(D) ausgewählt ist aus der Gruppe bestehend aus
(D1) den Dihydroxybenzolen, Trihydroxybenzolen und den Verbindungen der Formel (D-I): 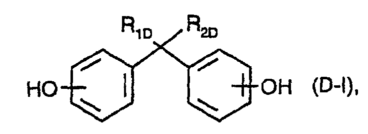 worin R_{1D} und R_{2D} ein Wasserstoffatom oder eine Methylgruppe bedeuten; und
(D2) den Verbindungen der Formel (DII): 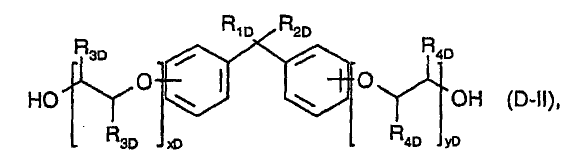 worin R_{1D} und R_{2D} jeweils ein Wasserstoffatom oder eine Methylgruppe;
R_{3D} und R_{4D} alle unabhängig voneinander jeweils ein Wasserstoffatom oder eine Methylgruppe und
xD sowie yD jeweils eine ganze Zahl von 1 bis 15 bedeuten.

4. Zusammensetzung nach einem der Ansprüche 1 bis 3, bei der die Komponente (D) aus (D2) phenolischen Verbindungen mit mindestens 2 Hydroxylgruppen besteht, die mit Ethylenoxid, Propylenoxid oder mit Ethylenoxid und Propylenoxid umgesetzt sind.

5. Zusammensetzung nach Anspruch 4, bei der die Komponente (D) aus (D2) den Verbindungen der Formel (D-IIa) besteht 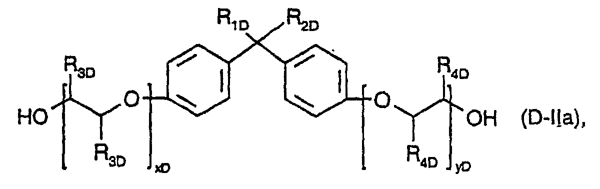 worin R_{1D} und R_{2D} beide ein Wasserstoffatom oder beide eine Methylgruppe;
R_{3D} und R_{4D} alle unabhängig voneinander ein Wasserstoffatom oder eine Methylgruppe und
xD sowie yD jeweils eine ganze Zahl von 1 bis 15 bedeuten.

6. Zusammensetzung nach einem der Ansprüche 1 bis 5, die als eine weitere Komponente (F) ein oder mehrere Di(meth-)acrylate enthält.

7. Zusammensetzung nach Anspruch 6, die Komponente (F) in einer Menge von 5 bis 40 Gewichtsprozent enthält.

8. Verfahren zur Herstellung eines gehärteten Produkts, bei dem man als gehärtetes Produkt einen dreidimensionalen Formkörper herstellt, indem man den Körper aus einer Zusammensetzung gemäss einem der Ansprüche 1 bis 7 mit Hilfe einer sich wiederholenden abwechselnden Abfolge von Verfahrensschritten (a) und (b) aufbaut, wobei in Schritt (a) eine Schicht der Zusammensetzung, deren eine Begrenzung die Oberfläche der Zusammensetzung ist, mit Hilfe von geeigneter Strahlung innerhalb eines Flächenbereiches gehärtet wird, der der gewünschten Querschnittsfläche des zu bildenden dreidimensionalen Körpers in der Höhe dieser Schicht entspricht, in Schritt (b) die frisch gehärtete Schicht mit einer neuen Schicht der strahlungshärtbaren flüssigen Zusammensetzung überschichtet wird, diese Abfolge der Schritte (a) und (b) solange wiederholt wird, bis ein Körper mit der gewünschten Form gebildet ist und dieser Körper gegebenenfalls nachgehärtet wird.

## Claims

1. A liquid, radiation-curable composition which in addition to a liquid, free-radically polymerizable component comprises at least the following additional components:
(A) from 40 to 80 per cent by weight of a liquid difunctional or more highly functional aliphatic or cycloaliphatic epoxy resin or of a liquid mixture consisting of difunctional or more highly functional aliphatic or cycloaliphatic epoxy resins;
(B) from 0.1 to 10 per cent by weight of a cationic photoinitiator or of a mixture of cationic photoinitiators; and
(C) from 0.1 to 10 per cent by weight of a free-radical photoinitiator or of a mixture of free-radical photoinitiators; and
(D) up to 40 per cent by weight of a hydroxy compound,
in which composition
component (D) is selected from the group consisting of:
(D1) phenolic compounds having at least 2 hydroxyl groups,
(D2) phenolic compounds having at least 2 hydroxyl groups, which are reacted with ethylene oxide, proptyene oxide or with ethylene oxide and propylene oxide,
(D3) trimethylolpropane, glycerol, castor oil and the compounds of the formula (D-III) and (D-IV):
[HO]_{zD}-R_{5D} (D-III), 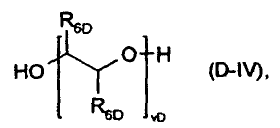
in which R_{5D} is an unbranched or branched (zD)-valent C₂-C₂₀alkane residue,
all radicals R_{6D}, independently of one another, are a hydrogen atom or a methyl group,
zD is an integer from 1 to 4 and
vD is an integer from 2 to 20, and
(D4) a mixture of at least 2 of the compounds mentioned under (D1) to (D3), and component (D) is present in the composition in a quantity of at least 2 per cent by weight; the free-radically polymerizable component comprises at least
(E) from 4 to 30 per cent by weight of at least one liquid poly(meth)acrylate having a (meth)acrylate functionality of more than 2; and
component (D) comprises substances which have aromatic carbon rings in their molecule.

2. A composition according to claim 1, which contains at least 5 per cent by weight of component (D).

3. A composition accenting to claim 1 or 2, in which component (D) is selected from the group consisting of
(D1) the dihydroxybenzenes. trihydroxybenzenes and the compounds of the formula (D-I): 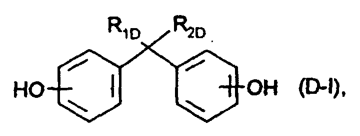 in which R_{1D} and R_{2D} are a hydrogen atom or a methyl group;
(D2) the compounds of the formula (D-II): 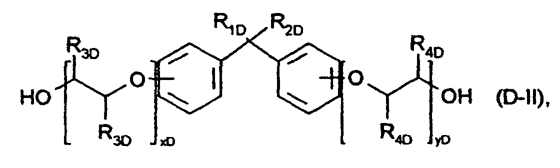 in which R_{1D} and R_{2D} are each a hydrogen atom or a methyl group;
R_{3D} and R_{4D} are all, independently of one another, a hydrogen atom or a methyl group, and
xD and yD are each an integer from 1 to 15.

4. Composition according to anyone of claims 1 to 3, in which component (D) consists of (D2) phenolic compounds having at least 2 hydroxyl groups which are reacted with ethylene oxide, propylene oxide or with ethylene oxide and propylene oxide.

5. Composition according to claim 4, in which component (D) consists of (D2) the compounds of the formula (D-IIa) 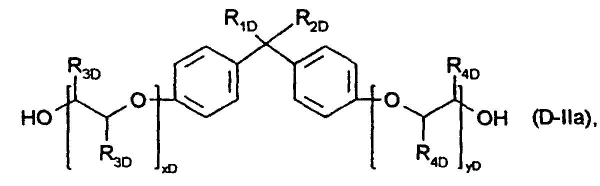 in which R_{1D} and R_{2D} are both a hydrogen atom or a methyl group;
R_{3D} and R_{4D} are all, independently of one another, a hydrogen atom or a methyl group, and
xD and yD are each an integer from 1 to 15.

6. A composition according according to anyone of claims 1 to 5, which as an additional component (F) contains one or more di(meth)acrylates.

7. A composition according to claim 6, which contains component (F) in a quantity of from 5 to 40 per cent by weight.

8. A method of producing a cured product, in which the cured product produced is a three-dimensional shaped article and in which the article is built up from a composition according to any one of claims 1 to 7 with the aid of a repeating, alternating sequence of steps (a) and (b); in step (a), a layer of the composition, one boundary of which is the surface of the composition, is cured with the aid of appropriate radiation within a surface region which corresponds to the desired cross-sectional area of the three-dimensional article to be formed, at the height of this layer, and in step (b) the freshly cured layer is covered with a new layer of the radiation-curable, liquid composition, this sequence of steps (a) and (b) being repeated until an article having the desired shape is formed and this article is, if desired, subjected to post-curing.

## Revendications

1. Composition liquide durcissable sous l'action du rayonnement, qui contient en plus d'un composant liquide polymérisable sous l'action de radicaux libres au moins les autres composants suivants :
(A) 40 à 80 pour cent en poids d'une résine époxyde liquide difonctionnelle ou à plus haute fonctionnalité aliphatique ou cycloaliphatique ou d'un mélange liquide constitué de résines époxydes difonctionnelles ou à plus haute fonctionnalité aliphatiques ou cycloaliphatiques,
(B) 0,1 à 10 pour cent en poids d'un photoinitiateur cationique ou d'un mélange de photoinitiateurs cationiques ; et
(C) 0,1 à 10 pour cent en poids d'un photoinitiateur radicalaire ou d'un mélange de photoinitiateurs radicalaires ; et
(D) jusqu'à 40 pour cent en poids d'un composé hydroxyle spécifique,
**caractérisé en ce que**,
le composant (D) est choisi parmi :
(D1) des composés phénoliques ayant au moins 2 groupes hydroxyle,
(D2) des composés phénoliques ayant au moins 2 groupes hydroxyle, qui ont réagi avec des groupes oxydes d'éthylène, oxyde de propylène ou avec des groupes oxyde d'éthylène et oxyde de propylène,
(D3) le triméthylolpropane, la glycérine, l'huile de ricin (huile de castor) et les composés des formules (D-III) et (D-IV) :
[HO]_{zD}-R_{5D} (D-III), 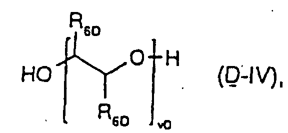
dans lesquelles R_{5D} représente un groupe alcane en C₂ à C₂₀ de valence zD non ramifié ou ramifié,
tous les R_{6D} représentent indépendamment les uns des autres un atome d'hydrogène ou un groupe méthyle,
zD représente un nombre entier allant de 1 à 4 et
vD représente un nombre entier allant de 2 à 20,
(D4) un mélange d'au moins 2 des composés mentionnés en (D1) à (D3),
et est contenu dans les compositions en une quantité d'au moins 2 pour cent en poids,
le composant polymérisable sous l'action de radicaux libres contient au moins
(E) 4 à 30 pour cent en poids d'au moins un poly(méth)acrylate liquide ayant une fonctionnalité (méth)acrylate supérieure à 2, et
le composant (D) contient des substances, qui présentent des cycles aromatiques dans leur molécule.

2. Composition selon la revendication 1, qui contient au moins 5 pour cent en poids du composant (D).

3. Composition selon l'une des revendication 1 ou 2, dans laquelle le composant
(D) est choisi parmi
(D1) les dihydroxybenzènes, les trihydroxybenzènes et
les composés de formule (D-1) : 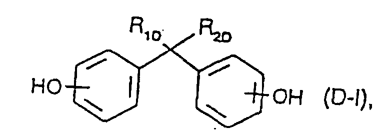 dans laquelle R_{1D} et R_{2D} représentent un atome d'hydrogène ou un groupe méthyle ;
(D2) les composés de formule (DII) : 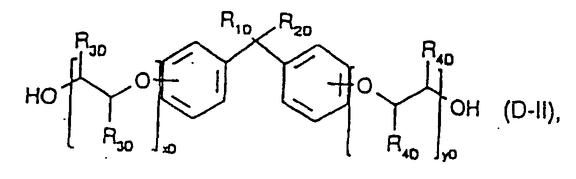 dans laquelle R_{1D} et R_{2D} représentent respectivement un atome d'hydrogène ou un groupe méthyle ;
R_{3D} et R_{4D} représentent tous indépendamment les uns des autres un atome d'hydrogène ou un groupe méthyle et
xD et yD représentent respectivement un nombre entier allant de 1 à 15.

4. Composition selon l'une des revendications 1 à 3, dans laquelle le composant (D) est constitué de composés phénoliques (D2) ayant au moins deux groupes hydroxyle, qui ont réagi avec l'oxyde d'éthylène, l'oxyde de propylène ou avec l'oxyde d'éthylène et l'oxyde de propylène.

5. Composition selon la revendication 4, dans laquelle le composant (D) de type (D2) est constitué de composés de formule (D-IIa) : 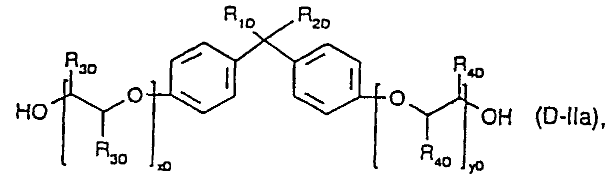 dans laquelle R_{1D} et R_{2D} représentent tous les deux un atome d'hydrogène ou tous les deux un groupe méthyle ;
R_{3D} et R_{4D} représentent tous indépendamment les uns des autres un atomes d'hydrogène ou un groupe méthyle et
xD et yD représentent respectivement un nombre entier allant de 1 à 15.

6. Composition selon l'une des revendications 1 à 5, qui contient comme autre composant (F) un ou plusieurs di(méth)acrylates.

7. Composition selon la revendication 6, qui contient le composant (F) en une quantité de 5 à 40 pour cent en poids.

8. Procédé pour la préparation. d'un produit durci, dans lequel on prépare comme produit durci une pièce de forme tridimensionnelle, dans lequel on construit la pièce en partant d'une composition selon l'une des revendications 1 à 7 au moyen d'une suite alternative répétitive d'étapes de procédé (a) et (b), dans laquelle à l'étape (a) on durcit une couche de la composition dont une limite est la surface de la composition, au moyen de rayonnement approprié à l'intérieur d'un domaine de la surface, qui correspond pour la hauteur de cette couche à la surface de la coupe transversale souhaitée de l'objet tridimensionnel à fabriquer, à l'étape (b) la couche fraîchement durcie est recouverte d'une nouvelle couche de la composition liquide durcissable sous l'action du rayonnement., on répète la suite des étapes (a) et (b) jusqu'à ce qu'on produise une pièce ayant la forme souhaitée et que cette pièce soit éventuellement durcie postérieurement.
